# EUROPEAN PATENT APPLICATION

(11) **EP 4 213 381 A1**
(43) Date of publication of application: **19.07.2023**
(21) Application number: 22152060.4
(22) Date of filing: 18.01.2022
(51) Int. Cl.: H03H 1/00, H03H 7/42, G01R 31/52, H02M 1/12, H02M 1/32

(54) **EMI FILTER WITH IMPROVED SAFETY**

(71) Applicant: Schaffner EMV AG, 4542 Luterbach (CH)
(72) Inventor: Amaducci, Alessandro, 4543 Deitingen (CH); Mazzola, Enrico, 4563 Gerlafingen (CH)
(74) Representative: P&TS SA (AG, Ltd.)

(57) **Abstract**

A safety device (120) for an automotive EMI filter that is connected in series with a filtering capacitor (C3). The safety device has normally a low impedance and does not alter the functioning of the filter, but it is configured to present an increased impedance in the event of a discharge. The device reduces the discharge current that can be accidentally conducted through a human body.

## Description

### Technical domain

The present invention concerns an electromagnetic compatibility filter for suppressing an unwanted noise component superimposed on an electric supply line. Embodiments of the invention concern a filter placed behind a motor drive unit on a DC power bus, in an electric vehicle, although this is not the only application of the invention.

### Related art

Electric systems in vehicles and in industry are becoming ever more complex and include a multitude of components that generate, or are liable to be disturbed by, electromagnetic interferences. Electric motors, for example, are often driven by electronic inverters that control the motor speed and torque by generating waveforms with variable frequency and amplitude. These systems provide high efficiency but generate a powerful electromagnetic noise.

Switching power converters are used in electric and hybrid vehicles, as well as in countless other applications such as driving stationary motors, battery chargers, photovoltaic systems, lighting control, computers, and other. In all these cases, the switching action of the converter is a source of electromagnetic noise that could, if it is not managed or attenuated, affect the functioning of other systems, or exceed normative limits.

Electric or electronic filters used to attenuate these unwanted interferences, called EMI filters in short, are used in all branches of electric engineering to improve reliability and respect existing norms. Well-designed filtering system are essential to the performance of many complex electric systems.

Electric and hybrid vehicles are equipped with different power converters in a very tight space. This coexistence represents a serious electromagnetic problem and demands efficient EMI filtering. Shielded cables can also are used to mitigate EMI but they are less preferable than EMI filters for costs and performance reasons. There are therefore technical and economic reasons to improve EMI filtering in vehicles.

It is known to use passive low-pass LC filters to attenuate EMI. While passive solutions do offer substantial attenuation, they have their limits. Magnetic components rated for the current levels used in modern electric vehicles are bulky, expensive, heavy, and not always suitable for mass production.

Active electronic EMI filters are also known. These devices are equipped with active electronic components such as amplifiers and transistors to provide better attenuation of unwanted noise components in a smaller package than what is possible by combining capacitors, inductors, and other passive elements.

Safety is an area of concern in all electric systems. In vehicles especially, safety must be assured in all circumstances, including after a vehicle crash. To this end, many electric vehicles are equipped with crash-detection breakers that insulate the main battery in the event of a crash. EMI filters, however, include capacitors that can store dangerous amounts of energy after the main battery has been shut off. For this reason, the presence of large capacitors in a filter is generally perceived as a safety hazard and there is a trend to reduce the capacitance connected between the power bus and ground.

The search for performance in electric vehicles pushes towards the adoption of higher voltage levels. Many vehicles that are produced today have a high voltage bus at 400 VDC nominal, but higher voltages are also used. It is expected that more vehicles will adopt higher voltage levels in the future, for example 800 VDC or even higher.

The values of the capacitance to ground that can be installed in high voltage automotive systems are regulated by normative standards. This problem is exacerbated by the adoption of higher voltage levels in vehicles such that the admissible capacitance to ground in a vehicle with an 800 V HV bus may be much lower than what is possible in a 400 V vehicle.

Reducing the capacitance to ground in an EMI filter usually requires a higher value of inductance to achieve the desired attenuation. This is not generally desirable, however, because magnetic components are bulkier, heavier and more costly than capacitors, and often exhibit higher losses.

There is therefore a need for filters with improved safety features that can include capacitors and operate on voltage levels higher than 400 V without presenting a safety hazard.

### Short disclosure of the invention

An aim of the present invention is the provision of an EMI filter that overcomes the shortcomings and limitations of the state of the art.

According to the invention, these aims are attained by the object of the attached claims, and especially by a filter that includes at least one combination of a capacitor and an active electronic device, wherein the active electronic device is configured to present a first impedance at frequencies in the attenuation band, and a second impedance at frequencies below the attenuation band, wherein the second impedance is higher than the first impedance.

Dependent claims present additional features of the invention that are important and advantageous, but not essential, such as the a resistive component of the second impedance of at least 100 Ω, preferably at least 500 Ω or, even better, more than 1 kΩ, a potential difference of 400 VDC or across two conductors between which the series combination is inserted, a nominal stored energy of 0.2 J or more in the capacitor, a ratio of ten between the first and second impedance, as well as a ratio of ten between the first impedance and the capacitor's impedance at the cut-off frequency of the filter.

The present disclosure will refer mostly to embodiments in which the filter of the invention is installed on a DC bus of an electric or hybrid vehicle to filter out the disturbances generated by the motor drive unit. This is an especially important and advantageous use case but is not the only one. In automotive applications, the filter of the invention could be used in all places where high power and voltage levels are present, and safety is a concern. This explicitly includes the charger of the vehicle, either on-board or off-board. In other embodiments, the filter of the invention may be applied to stationary battery systems for energy storage, photovoltaic plants, control of industrial motors and many other applications, both in DC and in AC systems.

### Short description of the drawings

Exemplar embodiments of the invention are disclosed in the description and illustrated by the drawings in which:
- Figure 1 illustrates schematically a possible structure of an electric vehicle in which the filter of the invention can be employed.
- Figure 2 shows a conventional passive EMI filter.
- Figure 3 is a model of the currents in an electric shock
- Figures 4a to 4d represent, in schematic fashion, possible structures for a safety device of the invention.
- Figure 5 plots the current passing through a human body in different situations.

### Examples of embodiments of the present invention

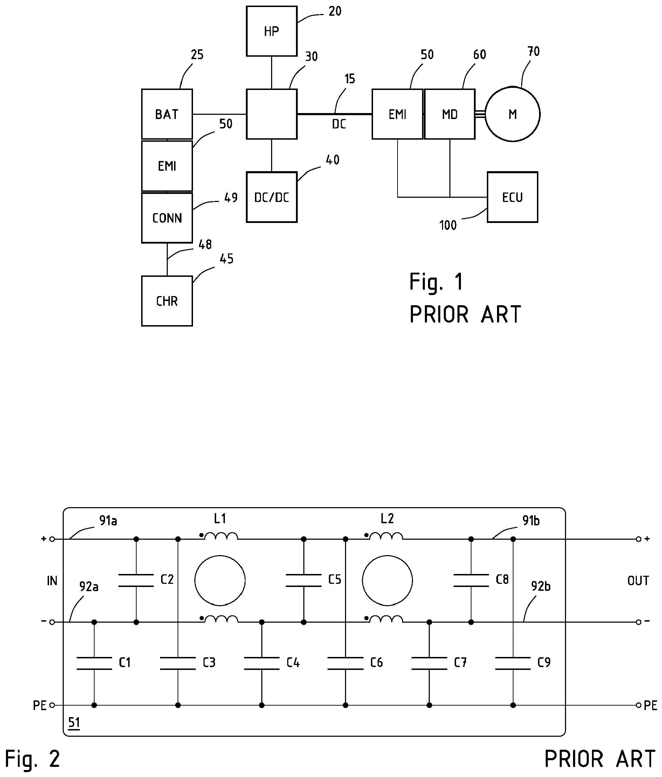

Figure 1 shows in a very simplified fashion the main components of an electric vehicle. The energy necessary to the traction is stored in a battery pack 45 and may be replenished by the charger 45 or - in the case of a hybrid vehicle - by a non-illustrated combustion motor. The battery pack 25 is connected to a power distribution unit 30 that distributes the power to various loads, for instance an DC/DC converter 40 for generating a 12V voltage for auxiliary equipment (entertainment, lights, on-board computers, etc.), and heat pumps 20 for the heating/ear conditioning. Importantly, a high-voltage DC bus 15 transmits the voltage of the battery to a motor drive unit 60 that includes an inverter generating multiphase AC waveforms suitable for the electric traction motor 70. An EMI filter 50 is inserted on the DC bus 15 at the supply point of the drive unit 60 to filter out the noise generated by the inverter in the latter.

The configuration of figure 1 is just one among the various possibilities and is provided merely as a non-limiting example of one possible use of the invention. The invention may be used in electric vehicles presenting various configurations, for example in series-hybrid, parallel-hybrid, plug-in-hybrid configurations that do not correspond to the diagram of figure 1. The invention is not limited to automotive applications, either.

Figure 1 shows two EMI filters 50, one between battery 25 and charging connector 49, and one on the DC side of the motor drive 60. The inventive EMI filter may be used in other positions without leaving the scope of the invention. Meaningful locations for EMI filters are: before and after the charger 45; after the battery 25; before the DC/DC converter 40. The charging unit 45 may be totally or in part installed after the connector 49. All these variants are included in the scope of the invention defined by the appended claims.

Figure 2 shows a possible structure of a passive EMI filter 51 as known in the art. The filter is configured as a two-stage LC filter with two common-mode chokes L1 and L2 and several capacitors connected between the positive and negative power rails (X-capacitors C2, C5, C8) or between a power rail and the protective earth conductor (Y-capacitors C1, C3, C4, C6, C7, C9). Such filters can be designed to provide an effective attenuation of noise at the price of an increase in size, weight, and manufacturing cost.

According to the needs, an EMC filter can be designed to attenuate differential and/or common mode noise. Common mode noise appears simultaneously with the same polarity on all the conductors of the supply bus and is often dominant. The filter of figure 2 is designed to attenuate primarily common-mode noise, but this is not an essential feature of the invention.

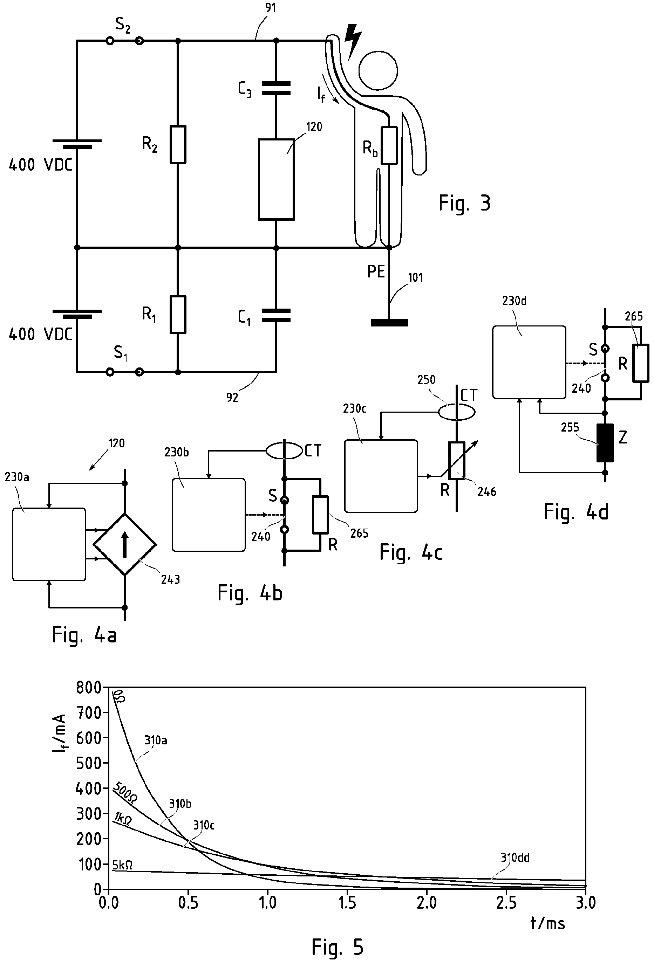

Figure 3 is a simplified diagram showing the electrical currents in a human body in an electric shock. A device in a vehicle includes capacitors C1, C3 that are normally charged at the nominal voltage of the high-voltage bus 91, 92. It may be supposed, to fix the ideas, that the nominal bus voltage is 400+400 VDC, which is a common choice in high-performance electric vehicles. The capacitors C1, C3 may correspond to those of the filter of figure 2 or not. Normally, the live conductors 91, 92 are insulated and/or inaccessible and do not present a safety hazard unless they are accidentally exposed, or the insulation is compromised, for example after a collision. In this event, there is a possibility that a person may enter directly or indirectly in contact with the live conductors and that the capacitors C1, C3 discharge accidentally through the human body.

A measure of safety is provided, conventionally, by the switches S1, S2 and the bleeding resistors R1, R2. The switches S1, S2 automatically break the connection between the bus conductors 91, 92 and the batteries in case of collision and, lacking the connection with the batteries, the bleeding resistors R1, R2 discharge the capacitors C1, C3. This discharge needs however several seconds such that a person touching the live conductor 91 and the chassis of the vehicle could receive a dangerous shock from the capacitor C3. Rb represents the resistance value of the human body, which is variable according to individuals and humidity of the skin, but is conventionally considered to be around 500 Ω.

Importantly, the filter of the invention includes a combination of a capacitor C3 with a safety device 120 that is configured to present a low impedance to noise signals, and a significantly higher impedance to currents arising from the discharge of capacitor C3. In this manner, the current If flowing through the body in case of a shock is considerably reduced.

The safety device of the invention is effective in reducing the discharge current traversing a human body both in the event of a direct contact and in the event of an indirect one. In embodiments, the impedance of the safety device may become infinite in the event of a discharge. In these cases, the safety device behaves like a switch and effectively disconnects the capacitor, preventing any discharge current.

The represented example has the safety device in a "low-side" position between the capacitor C3 and the ground connector. The safety device 120 could be also connected in a "high-side" position between the capacitor C3 and the conductor 91.

Capacitor C3 and safety device 120 are represented in a series connection in figure 3. By definition they carry the same current. It is important for the invention that the current flowing through the safety device 120 and the current flowing through the capacitor C3 are strictly related. A perfect equality and a pure series connection are not essential, however. In this light, the invention includes variants in which the combination is not strictly a series connection. One could for example connect the bleeding resistor R2 to the common node between C3 and the safety device 120. In this way part of the current flowing through the safety device would branch in the bleeding resistor R2, but this would not change essentially the functioning of the invention. In the present disclosure the expression "connected in series" encompasses all these cases with slight deviation from a "pure" series connection, i.e. with derivation paths that carry unimportant currents.

To illustrate the effect of the safety device 120, reference is made to the plot of Figure 5 that shows the time development of the fault current If for four different values of the effective impedance of the safety device 120. The plot line 250 shows the transient fault current when the impedance of the safety device 120 is zero - i.e. the safety device 120 is not there - The curve has been computed assigning typical values to the capacitance of C3 and to the resistance Rb. Plot lines 255, 260 and 290 show the same current when the impedance of the safety device 120 is a pure resistance of 500 Ω, 1000 Ω and 5000 Ω. It appears that as the resistance value rises the average current becomes lower and the duration longer. The invention relies on the realization that the hazard of cardiac fibrillation depends strongly on the rms current traversing the hearth. Inserting a resistance or an impedance in the discharge path considerably reduces the danger and improves the safety of the filter, without changing substantially the electrostatic energy stored in the capacitor.

Preferably, the safety device 120 is configured to exhibit a resistive impedance during the discharge. This is not an essential feature of the invention, however, and the safety device may also present a complex impedance including a real part (a resistance) and an imaginary part, either of capacitive or inductive nature.

It is not required that the safety device 120 be a linear device. The invention also includes realizations in which the safety device is not linear and exhibits a dynamic nonconstant impedance. The invention explicitly comprises realizations in which the safety has diodes, transistors or other nonlinear elements that contribute significantly to its impedance.

During normal functioning, the safety device should interfere as least as possible with the filter function. This is achieved through a low impedance during normal functioning. The distinction between a normal functioning and a dangerous discharge can be obtained in several ways, all compatible with the invention. In a preferable embodiment, the safety device exhibits a first impedance at high frequency, where the noise is expected to occur, and a second impedance at low frequency that is where the energy of the discharge lies. In addition, or in alternative, other measurements can be used to distinguish between normal filtering and dangerous discharges, including for example the duration of the pulses and the polarity of the current. One expects in fact, during a shock discharge, a negative pulse of current of several milliseconds while the noise that should be filtered can be regarded as a sum of bipolar signals, sinusoidal or impulsive, at several kHz or above.

The first impedance is configured to be as low as possible not to degrade filter performances, while the second impedance is considerably higher to slow down and attenuate the discharge current. Preferably, the first impedance is at least ten time smaller than the impedance of the capacitor at the cut-off frequency of the filter.

Preferably the second impedance is essentially resistive. Preferably, the resistive part of the second impedance is at least 100 Ohm or, more preferably, at least equal or above the resistance of the human body conventionally set as 500 Ohm, better if above 1000 Ohm.

The safety device 120 can have any structure compatible with the claimed function and presenting the variable impedance disclosed above. In possible embodiments, the safety device 120 is an active electronic device that is configured to sense the characteristics of the current flowing through the capacitor, or of the voltage across the capacitor, or any other suitable electric signal that indicates a discharge condition and includes a controlled actuator that gives rise to the desired impedance during a discharge. The invention is not limited to this kind of devices, however and may include other realization that inherently exhibit the desired impedances.

Figure 4a presents schematically a possible embodiment that includes a control unit 230a sensing the voltage difference across the safety device 120 and controls a voltage-controlled current source 243 in such a way that the device 120 presents the desired first and second impedances.

The control unit 230a can be realized in many ways and may consist in an analog filter or in a nonlinear analog circuit, and may include comparators, logic devices, A/D and D/A converter, timers and microcontrollers. In this latter case, the impedance of the safety device may be controlled by a software code run by the microcontroller.

The example of figure 4a is based on sensing the voltage drop across the whole safety device 120. This is not the only manner of gathering the necessary input signal, however. The controller unit may be responsive to the current flowing through the safety device, as shown in figures 4b, 4c, or to a voltage drop across a shunt impedance, as shown in figure 4d, or to any other significant electric signal. The controller unit may be responsive to a signal indicating that the vehicle has suffered a collision, for example from a crash sensor, or from the ECU. In a possible alternative, the controller unit may detect that the safety switches S1, S2 that separate the main battery from the DC bus (see figure 3) have been actuated.

Concerning figure 4c, the controller unit 230c is configured to receive a current signal from a suitable current sensor 250, for example a current transformer a Hall sensor or a shunt resistor. The controller unit 230c controls a variable resistor 246 that may be a transistor or any other suitable device.

The actuator used to change the impedance needs not be a continuous one but could also consist in the choice of one among a finite number of states. In a possible implementation the actuator may be a switch or a group of switches inserting one or several resistor or complex inductive elements in the current path. Such is the case of the circuit of figure 4b where the controller 230b is configured to drive a controlled switch 240 that, when open, causes the current to flow through the resistor 265. The resistor 165 could be omitted altogether, in which case the safety device 120 has an open state of infinite impedance.

Figure 4d represents another variant where the controller 230d reads an input signal that is the voltage drop across an impedance 255 in the current path and operates on a switch much like the example of figure 4b.

It is easy to add the safety device of the invention to existing filters. Insofar as the safety device adds a negligible impedance during the normal functioning of the filter and intervenes only in the event of a discharge, there is little need to change the dimensioning or the topology of the filter. In this way, the invention provides an excellent opportunity of upgrading and/or retrofitting existing products.

It is understood that the four variants do not exhaust the space of possibilities and that the invention includes many more.

### Reference Symbols of the Figures

- 15: supply line, DC bus
- 20: heat pump
- 25: battery pack
- 30: power distribution unit
- 40: DC/DC converter
- 45: charger
- 48: charge line
- 49: connector
- 50: EMC filter
- 51: passive filter
- 60: motor drive unit
- 70: motor
- 75: load, victim device
- 91: positive conductor
- 91a: positive supply, input (source side)
- 91b: positive supply, output (load side)
- 92: negative conductor
- 92a: negative supply, input (source side)
- 92b: negative supply, output (load side)
- 100: ECU
- 101: active filter stage (power stage)
- 110: current sense, current transformer
- 120: amplifier, signal conditioning
- 230a-d: control unit
- 240: switch
- 243: voltage-controlled current source
- 246: variable resistor, transistor
- 250: current probe, current transformer
- 255: shunt impedance
- 265: resistor
- 310a-d: discharge current plots

## Claims

1. A safety device for an automotive EMI filter that attenuates noise in an attenuation band, the filter including at least one combination of a capacitor and the safety device, wherein the safety device is configured to present a first impedance during normal operation of the filter and a second impedance higher than the first impedance when the capacitor is being discharged through a human body.

2. The safety device of the preceding claim, wherein the safety filter is configured to exhibit the first impedance for signals with frequency in the attenuation band of the filter and the second impedance for signals having frequencies below the attenuation band.

3. The safety device of the preceding claim, wherein the first impedance is, in absolute value, at least ten times smaller than the impedance of the capacitor.

4. The safety device of the preceding claim, wherein at a cut-off frequency of the EMI filter the first impedance is, in absolute value, at least ten times smaller than the impedance of the capacitor.

5. The safety device of any one of the preceding claims, the preceding claim, wherein the second impedance has a resistive component of at least 100 Ohm, preferably at least 500 Ohm, more preferably at least 1000 Ohm.

6. The safety device of any one of the preceding claims, wherein the capacitor and the safety device are combined in series.

7. The safety device of any one of the preceding claims, wherein the safety device is an active electronic device.

8. The safety device of any one of the preceding claims, wherein the second impedance is essentially infinite.

9. The safety device of any one of the preceding claims, wherein the safety device exhibits nonlinear behaviour when the capacitor is being discharged.

10. The safety device of the preceding claim including a control unit configured to sense a feature of the current flowing through the capacitor, or of the voltage across the capacitor, or any other suitable electric signal indicating a discharge condition and to control an actuator that gives rise to the second impedance during a discharge.

11. The safety device of the preceding claim wherein the actuator is a variable resistor or a switch or a controlled source.

12. An automotive EMI filter including at least one capacitor and the safety device of any one of the preceding claims connected in series between two conductors with a nominal potential difference of at least 400 VD.

13. The automotive EMI filter of the preceding claim, wherein the capacitor stores an energy higher than 0.2 J when it is charged at the nominal potential difference.

14. A method of improving the safety of an electric vehicle comprising detecting an electric signal that indicates or suggests that a capacitor is discharging itself through a human body and raising an impedance of a safety device connected in series with the capacitor.

15. A method of upgrading and/or retrofitting existing filter products, comprising adding a safety device in series with a capacitor, wherein the safety device is configured to present a first impedance during the normal operation of the filter and a second impedance higher than the first impedance when the capacitor is being discharged accidentally through a human body.
